# EUROPEAN PATENT APPLICATION

(11) **EP 4 838 776 A1**
(43) Date of publication of application: **11.11.2026**
(21) Application number: 26173945.2
(22) Date of filing: 22.04.2026
(51) Int. Cl.: H02M 7/483, H02M 1/38, H02M 3/00, H02M 3/158, H02M 3/335, H02M 7/487, H02M 7/5387

(54) **POWER SWITCH SYSTEM AND CONTROL METHOD THEREFOR**

(30) Priority: 08.05.2025 US 202563802276 P; 09.04.2026 US 202619642935
(71) Applicant: DELTA ELECTRONICS, INC., 11491 Taipei (TW)
(72) Inventor: Zhang, Chi, Morrisville, NC, 27560 (US); Wang, Ruxi, Morrisville, NC, 27560 (US); Barbosa, Peter Mantovanelli, 320023 Taoyuan City (TW); Wang, Dakai, Morrisville, NC, 27560 (US)
(74) Representative: Uexküll & Stolberg

(57) **Abstract**

A power switch system (1, 1a, 1b, 1c, 1d) and a control method are provided. The power switch system (1, 1a, 1b, 1c, 1d) includes a subcircuit module (3) including N serial-half-bridge subcircuits (31, 32, 33) connected in cascade. Each serial-half-bridge subcircuit (31, 32, 33) includes a first switch (S1), a second switch (S2), a third switch (S3), a fourth switch (S4), a first capacitor (C1) and a second capacitor (C2). The first switch (S1), the second switch (S2), the third switch (S3) and the fourth switch (S4) are connected in series. The first capacitor (C1) is coupled to the first switch (S1) and the second switch (S2). The second capacitor (C2) is coupled to the third switch (S3) and the fourth switch (S4). A plurality of control signals are generated according to a first voltage across the first capacitor (C1) and a second voltage across the second capacitor (C2). A first timing parameter between the first switch (S1) and the second switch (S2) and a second timing parameter between the third switch (S3) and the fourth switch (S4) are adjusted according to the plurality of control signals.

## Description

### FIELD OF THE INVENTION

This present disclosure relates to a power switch system and a control method of the power switch system, and more particularly to a power switch system and a control method for the power switch system with enhancing efficiency.

### BACKGROUND OF THE INVENTION

The power switch is a major component in the power conversion system. The high-voltage device with the power switch is desired for simplifying architecture of the power conversion system in medium-voltage applications. For example, a two-level phase leg with 10kV SiC device operates at 6kV bus voltage. The complexity of the power conversion system is dramatically reduced. However, the high-voltage device (>6.5kV) is not mature in the current industry and suffers a very low device yield and high cost. Moreover, the high-voltage device faces one dimension barrier limitation because of the structure limitation. The conduction loss is quite significant. Furthermore, the high-voltage device with single switch also has the challenges of thermal dissipation barrier. Moreover, the rate of change of voltage with respect to time during the operation is strong so as to create strong harmonics and challenges for the system level integration or raise the requirement of the output filter and insulation.

Therefore, it is needed to provide a power switch system and a control method for the power switch system to address the drawbacks encountered by the prior arts.

### SUMMARY OF THE INVENTION

The present disclosure provides a power switch system and a control method for the power switch system. The power switch system includes a controller. The controller is configured to adjust a first deadtime between the first switch and the second switch and a second deadtime between the third switch and the fourth switch according to a plurality of control signals. Consequently, when the voltage across the first capacitor and the voltage across the second capacitor are not balanced first, the voltage across the first capacitor and the voltage across the second capacitor are adjusted according to different situations. The voltage difference between the second capacitor and the first capacitor is reduced. Consequently, the rate of change of voltage with respect to time of the power switch system during the operation is reduced. The efficiency of the power switch system is enhanced. The EMI noise of the power switch system is reduced.

In accordance with an aspect of the present disclosure, a control method of a power switch system is provided. The power switch system has a first terminal and a second terminal. The control method includes the following steps. A subcircuit module is provided. The subcircuit module includes N serial-half-bridge subcircuits connected in cascade between the first terminal and the second terminal. Each of the N serial-half-bridge subcircuits includes a first switch, a second switch, a third switch, a fourth switch, a first capacitor and a second capacitor. The first switch, the second switch, the third switch and the fourth switch are connected in series. The first capacitor is coupled to the first switch and the second switch. The second capacitor is coupled to the third switch and the fourth switch. A plurality of control signals are generated by a controller according to a first voltage across the first capacitor and a second voltage across the second capacitor. A first timing parameter between the first switch and the second switch and a second timing parameter between the third switch and the fourth switch are adjusted according to the plurality of control signals.

In accordance with another aspect of the present disclosure, a control method of a power switch system is provided. The power switch system includes a first terminal and a second terminal. The control method includes the following steps. A subcircuit module is provided. The subcircuit module includes N serial-half-bridge subcircuits connected in cascade between the first terminal and the second terminal. Each of the N serial-half-bridge subcircuits includes four switches connected in series and two capacitors. The two capacitors are coupled to the four switches. A plurality of control signals are generated by a controller to form a delay time between each of the N serial-half-bridge subcircuits and an adjacent one of the N serial-half-bridge subcircuits and the four switches of the N serial-half-bridge subcircuits are controlled by the controller according to a plurality of control sequences that are cyclically arranged.

In accordance with another aspect of the present disclosure, a power switch system is provided. The power switch system includes a first terminal, a second terminal, a subcircuit module and a controller. The subcircuit module includes N serial-half-bridge subcircuits connected in cascade between the first terminal and the second terminal. Each of the N serial-half-bridge subcircuits includes a first switch, a second switch, a third switch, a fourth switch, a first capacitor and a second capacitor. The first switch, the second switch, the third switch and the fourth switch are connected in series. The first capacitor is coupled to the first switch and the second switch. The second capacitor is coupled to the third switch and the fourth switch. The controller is configured to generate a plurality of control signals according to voltages of the first capacitor and the second capacitor. A first timing parameter between the first switch and the second switch and a second timing parameter between the third switch and the fourth switch are adjusted according to the plurality of control signals.

The above contents of the present disclosure will become more readily apparent to those ordinarily skilled in the art after reviewing the following detailed description and accompanying drawings, in which:

### BRIEF DESCRIPTION OF THE DRAWINGS

FIG. 1 is a schematic circuit view illustrating a power switch system according to a first embodiment of the present disclosure;
FIG. 2 is a schematic circuit view illustrating a serial-half-bridge subcircuit of a subcircuit module of the power switch system of FIG. 1;
FIG. 3A shows waveforms of operations of the switches of the serial-half-bridge subcircuit of the power switch system of FIG. 1, wherein voltage across a first capacitor is greater than voltage across a second capacitor of the serial-half-bridge subcircuit;
FIGS. 3B to 3E are schematic circuit views showing the current directions of the serial-half-bridge subcircuit of the power switch system of FIG. 3A;
FIG. 4A shows waveforms of operations of the switches of the serial-half-bridge subcircuit of the power switch system of FIG. 1, wherein voltage across a first capacitor is less than voltage across a second capacitor of the serial-half-bridge subcircuit;
FIGS. 4B to 4E are schematic circuit views showing the current directions of the serial-half-bridge subcircuit of the power switch system of FIG. 4A;
FIG. 5A is a schematic circuit view illustrating a power switch system according to a second embodiment of the present disclosure;
FIG. 5B is a schematic circuit view illustrating a power switch system according to a third embodiment of the present disclosure;
FIG. 5C is a schematic circuit view illustrating a power switch system according to a fourth embodiment of the present disclosure;
FIG. 5D is a schematic circuit view illustrating a power switch system according to a fifth embodiment of the present disclosure;
FIG. 6A shows waveforms of the output voltage of the subcircuit module of the power switch system of the present disclosure;
FIG. 6B shows waveforms of operations of the first switches of the three serial-half-bridge subcircuits of the power switch system of FIG. 1;
FIG. 7 is a flow chart illustrating the control method for the power switch system of FIG. 1 according to a first embodiment of the present disclosure; and
FIG. 8 is a flow chart illustrating the control method for the power switch system of FIG. 1 according to a second embodiment of the present disclosure.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description. It is not intended to be exhaustive or to be limited to the precise form disclosed.

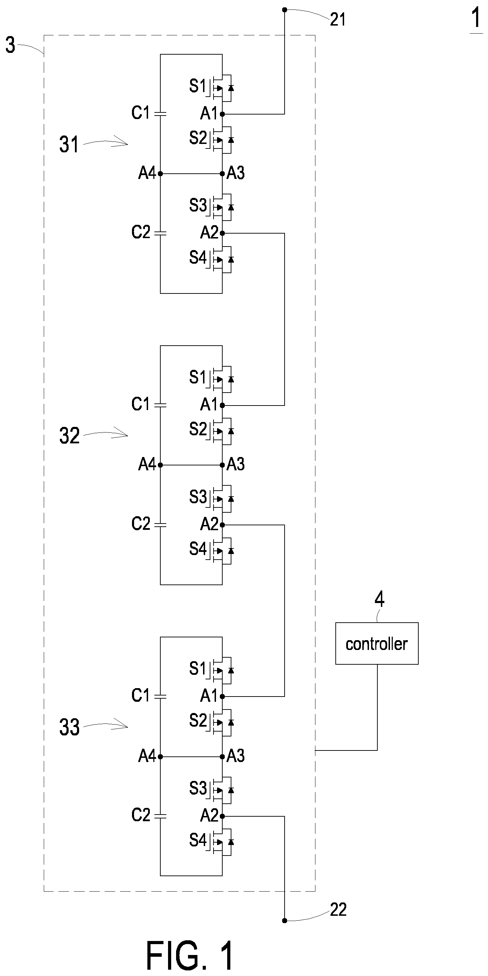

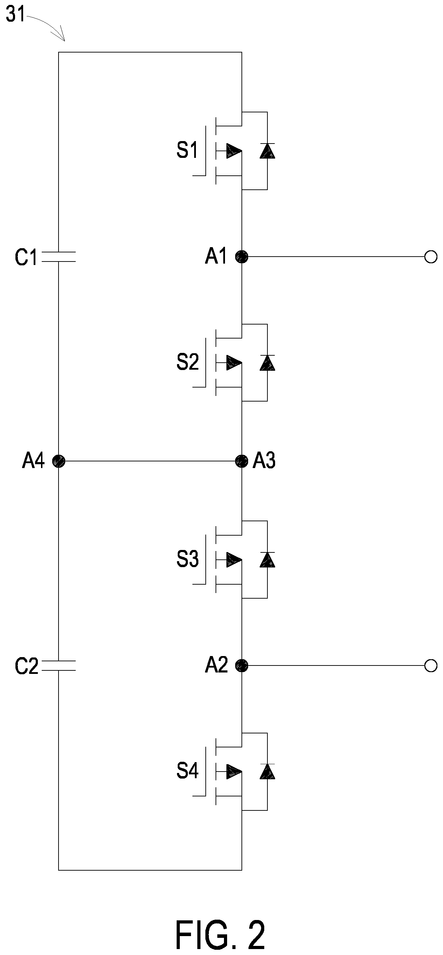

FIG. 1 is a schematic circuit view illustrating a power switch system according to a first embodiment of the present disclosure. FIG. 2 is a schematic circuit view illustrating a serial-half-bridge subcircuit of a subcircuit module of the power switch system of FIG. 1. As shown in FIG. 1, the power switch system 1 includes a first terminal 21, a second terminal 22, a subcircuit module 3 and a controller 4. The power switch system 1 is connected to a load or another circuit (not shown) through the first terminal 21 and the second terminal 22. The subcircuit module 3 includes three serial-half-bridge subcircuits, i.e., a first serial-half-bridge subcircuit 31, a second serial-half-bridge subcircuit 32 and a third serial-half-bridge subcircuit 33. Certainly, the number of the serial-half-bridge subcircuits is not limited to three and can be varied according to practical requirements.

The first serial-half-bridge subcircuit 31, the second serial-half-bridge subcircuit 32 and the third serial-half-bridge subcircuit 33 are connected in cascade between the first terminal 21 and the second terminal 22. The circuitry topology of the first serial-half-bridge subcircuit 31 is shown in FIG. 2 as an example. The first serial-half-bridge subcircuit 31 includes a first switch S1, a second switch S2, a third switch S3, a fourth switch S4, a first capacitor C1 and a second capacitor C2. In an embodiment, the first switch S1, the second switch S2, the third switch S3 and the fourth switch S4 are MOSFETs and connected in series. A first midpoint A1 is formed between the first switch S1 and the second switch S2. A second midpoint A2 is formed between the third switch S3 and the fourth switch S4. A first connection node A3 is formed between the second switch S2 and the third switch S3. The first capacitor C1 is coupled to the first switch S1 and the second switch S2. The second capacitor C2 is coupled to the third switch S3 and the fourth switch S4. A second connection node A4 is formed between the first capacitor C1 and the second capacitor C2. The second connection node A4 is connected to the first connection node A3. The circuitry topologies of the second serial-half-bridge subcircuit 32 and the third serial-half-bridge subcircuit 33 are similar to the first serial-half-bridge subcircuit 31, and are not redundantly described hereinafter. In some embodiments, the first switch S1, the second switch S2, the third switch S3 and the fourth switch S4 are IGBTs, BJTs or other semiconductor switches.

As shown in FIG. 1, the first midpoint A1 of the first serial-half-bridge subcircuit 31 is connected to the first terminal 21. The first midpoint A1 of the second serial-half-bridge subcircuit 32 is connected to the second midpoint A2 of the first serial-half-bridge subcircuit 31. The first midpoint A1 of the third serial-half-bridge subcircuit 33 is connected to the second midpoint A2 of the second serial-half-bridge subcircuit 32. The second midpoint A2 of the third serial-half-bridge subcircuit 33 is connected to the second terminal 22.

In an embodiment, the controller 4 is a standard compensator, such as a Proportional-Integral-Derivative (PID) controller or various types of zero-pole compensators, and electrically connected to the subcircuit module 3. The controller 4 is configured to generate a plurality of control signals according to the comparison result between a first voltage across the first capacitor C1 and a second voltage across the second capacitor C2. The controller 4 is configured to adjust a first deadtime between the first switch S1 and the second switch S2 and a second deadtime between the third switch S3 and the fourth switch S4 according to the plurality of control signals. For example, the first switch S1, the second switch S2, the third switch S3 and the fourth switch S4 are controlled to be turned on or turned off by a first control signal, a second control signal, a third control signal and a fourth control signal, respectively. In an embodiment, the first control signal and the second control signal are complementary, and the third control signal and the fourth control signal are complementary, but it is not limited thereto. The detailed control method executed by the controller 4 is described below.

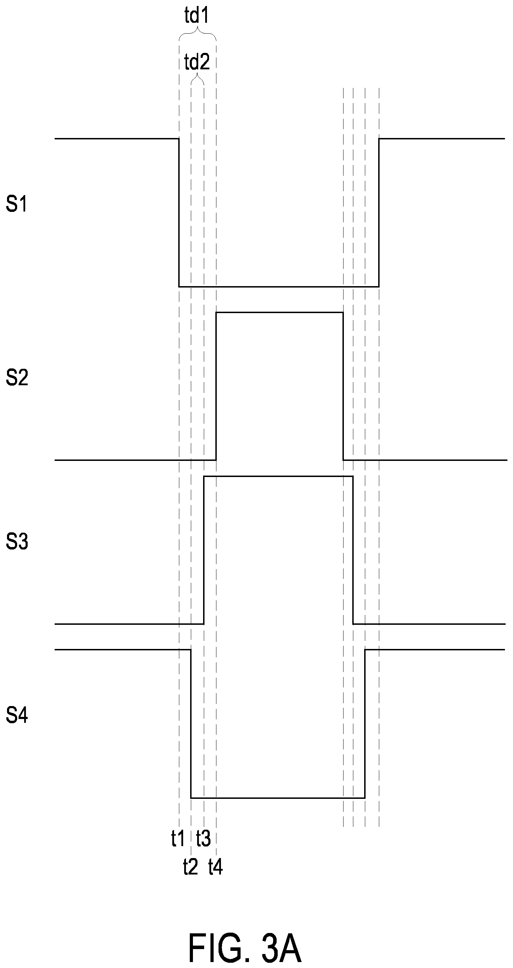

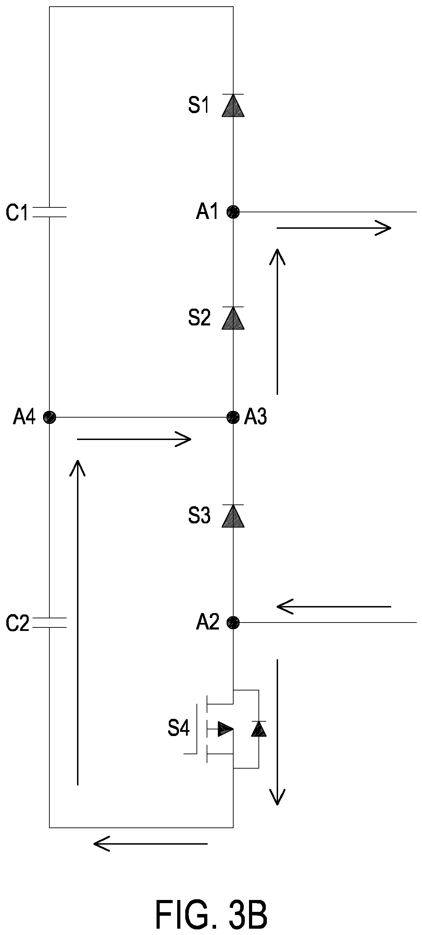

FIG. 3A shows waveforms of operations of the switches of the serial-half-bridge subcircuit of the power switch system of FIG. 1, wherein voltage across a first capacitor is greater than voltage across a second capacitor of the serial-half-bridge subcircuit. FIGS. 3B to 3E are schematic circuit views showing the current directions of the serial-half-bridge subcircuit of the power switch system of FIG. 3A. When the controller 4 determines that the voltage across the first capacitor C1 is greater than the voltage across the second capacitor C2, as shown in FIG. 3A, the controller 4 generates the first control signal, the second control signal, the third control signal and the fourth control signal to control the operations of the first switch S1, the second switch S2, the third switch S3 and the fourth switch S4, and adjusts a first deadtime td1 between the first switch S1 and the second switch S2 and a second deadtime td2 between the third switch S3 and the fourth switch S4. In this embodiment, the first deadtime td1 is adjusted to be greater than the second deadtime td2.

In an embodiment, the first deadtime td1 refers to the time interval during which the first switch S1 and the second switch S2 are transitioning from one state to the other state. The second deadtime td2 refers to the time interval during which the third switch S3 and the fourth switch S4 are transitioning from one state to the other state. In other embodiments, the same effect is not only achieved by adjusting the deadtime, but also by adjusting the pulse width or duty cycle of the first control signal, the second control signal, the third control signal and the fourth control signal. Adjusting the deadtime, the pulse width, the duty cycle, or other methods can all be used to regulate the switching in these embodiments. Namely, the timing parameter is adjusted to regulate the switching in these embodiments.

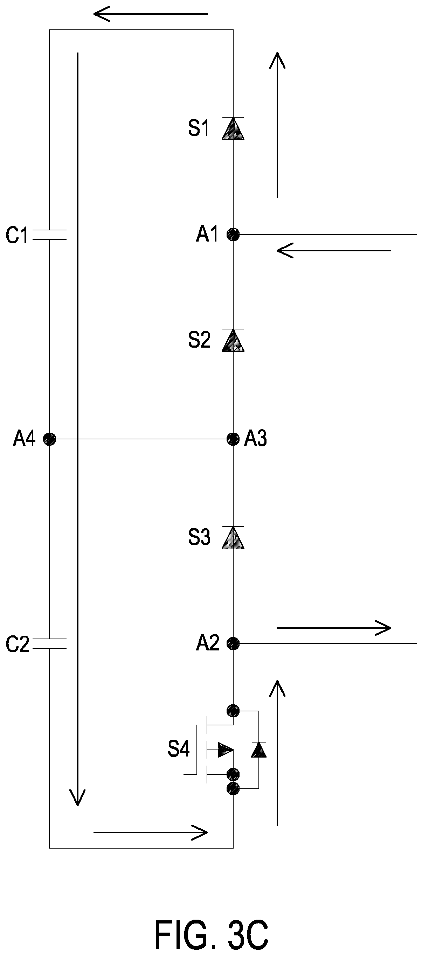

In the time interval between t1 and t2, the first switch S1, the second switch S2 and the third switch S3 are turned off, and the fourth switch S4 is turned on. When a load current of the load is positive, as shown in FIG. 3B, the load current is flowed through the second midpoint A2, the fourth switch S4, the second capacitor C2, the second connection node A4, the first connection node A3, the second switch S2 and the first midpoint A1 in sequence. Namely, the second capacitor C2 is discharged. The voltage across the second capacitor C2 is reduced, and the voltage across the first capacitor C1 is maintained. The voltage difference between the second capacitor C2 and the first capacitor C1 is reduced. When a load current of the load is negative, as shown in FIG. 3C, the load current is flowed through the first midpoint A1, the first switch S1, the first capacitor C1, the second capacitor C2, the fourth switch S4 and the second midpoint A2 in sequence. Namely, the voltage across the first capacitor C1 and the voltage across the second capacitor C2 are enhanced, respectively. The voltage difference between the second capacitor C2 and the first capacitor C1 is maintained.

In the time interval between t2 and t3, the first switch S1, the second switch S2, the third switch S3 and the fourth switch S4 are turned off. Regardless of whether a load current of the load is positive or negative, the voltage difference between the second capacitor C2 and the first capacitor C1 is maintained.

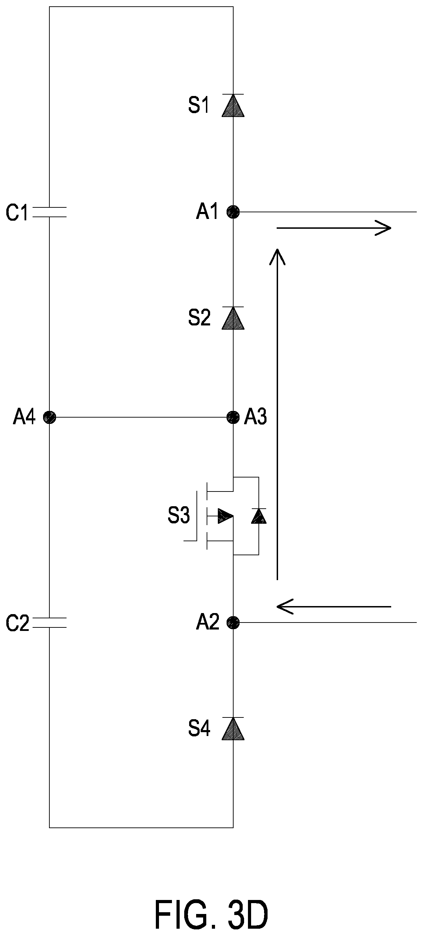

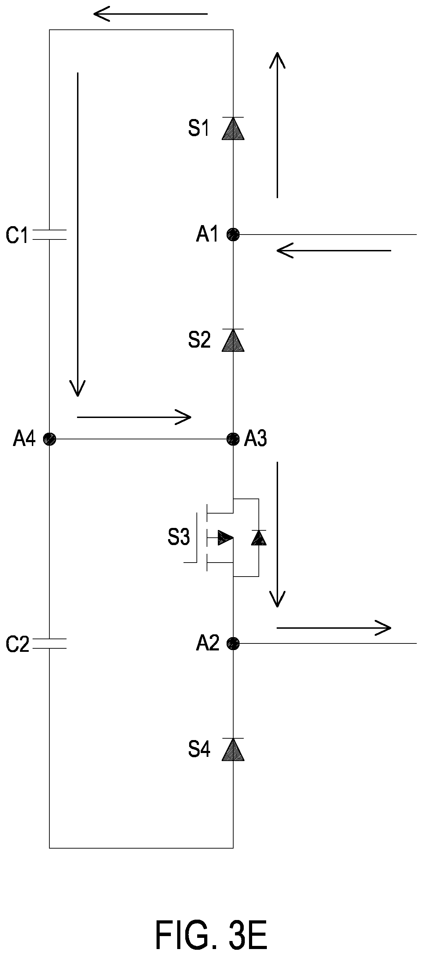

In the time interval between t3 and t4, the first switch S1, the second switch S2 and the fourth switch S4 are turned off, and the third switch S3 is turned on. When a load current of the load is positive, as shown in FIG. 3D, the load current is flowed through the second midpoint A2, the third switch S3, the second switch S2 and the first midpoint A1 in sequence. Namely, the voltage across the first capacitor C1 and the voltage across the second capacitor C2 are maintained, respectively. The voltage difference between the second capacitor C2 and the first capacitor C1 is maintained. When a load current of the load is negative, as shown in FIG. 3E, the load current is flowed through the first midpoint A1, the first switch S1, the first capacitor C1, the second connection node A4, the first connection node A3, the third switch S3 and the second midpoint A2 in sequence. Namely, the first capacitor C1 is charged. The voltage across the first capacitor C1 is enhanced, and the voltage across the second capacitor C2 is maintained. The voltage difference between the second capacitor C2 and the first capacitor C1 is reduced.

Namely, in the time interval between t1 and t2, when the load current is positive, the second capacitor C2 is discharged. In the time interval between t3 and t4, when the load current is negative, the first capacitor C1 is charged. The voltage difference between the second capacitor C2 and the first capacitor C1 is reduced when the voltage across the first capacitor C1 is greater than the voltage across the second capacitor C2. The voltage is balanced.

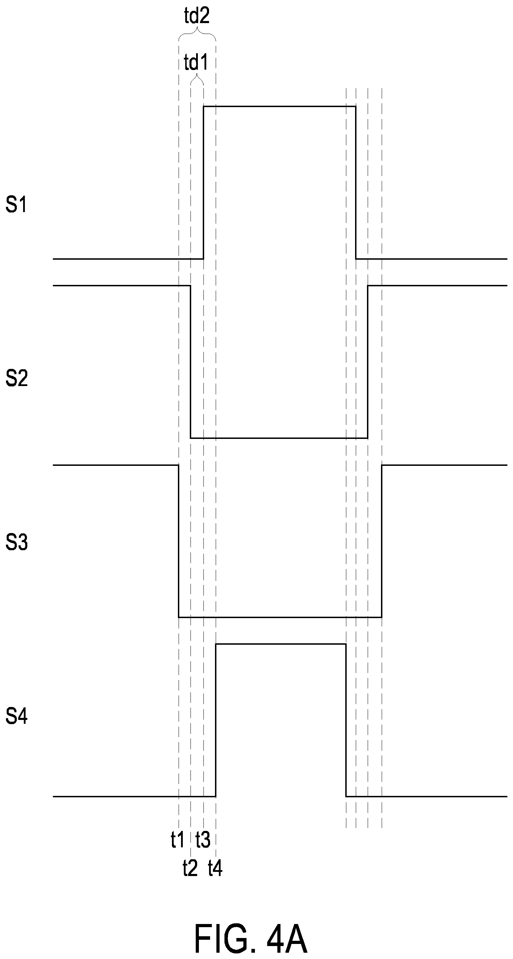

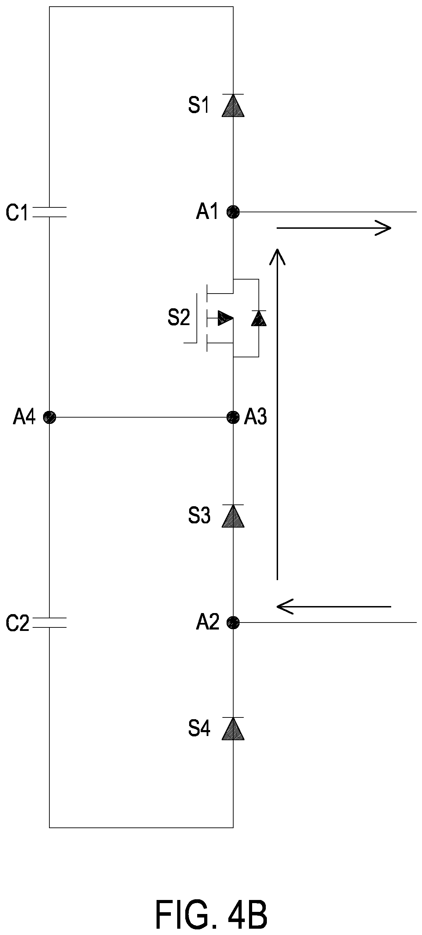

FIG. 4A shows waveforms of operations of the switches of the serial-half-bridge subcircuit of the power switch system of FIG. 1, wherein voltage across a first capacitor is less than voltage across a second capacitor of the serial-half-bridge subcircuit. FIGS. 4B to 4E are schematic circuit views showing the current directions of the serial-half-bridge subcircuit of the power switch system of FIG. 4A. When the controller 4 determines that the voltage across the first capacitor C1 is less than the voltage across the second capacitor C2, as shown in FIG. 4A, the controller 4 generates the first control signal, the second control signal, the third control signal and the fourth control signal to control the operations of the first switch S1, the second switch S2, the third switch S3 and the fourth switch S4, and adjusts a first deadtime td1 between the first switch S1 and the second switch S2 and a second deadtime td2 between the third switch S3 and the fourth switch S4. In this embodiment, the first deadtime td1 is adjusted to be less than the second deadtime td2.

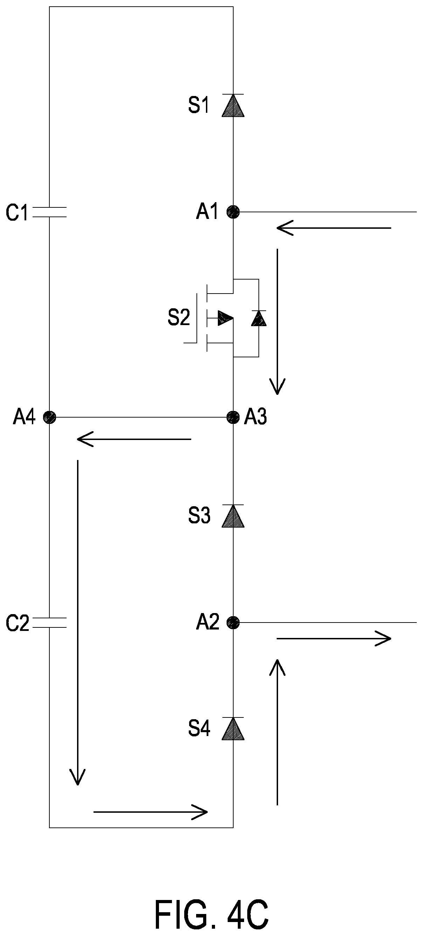

In the time interval between t1 and t2, the first switch S1, the third switch S3 and the fourth switch S4 are turned off, and the second switch S2 is turned on. When a load current of the load is positive, as shown in FIG. 4B, the load current is flowed through the second midpoint A2, the third switch S3, the second switch S2 and the first midpoint A1 in sequence. Namely, the voltage across the first capacitor C1 and the voltage across the second capacitor C2 are maintained, respectively. The voltage difference between the second capacitor C2 and the first capacitor C1 is maintained. When a load current of the load is negative, as shown in FIG. 4C, the load current is flowed through the first midpoint A1, the first switch S1, the first connection node A3, the second connection node A4, the second capacitor C2, the fourth switch S4 and the second midpoint A2 in sequence. Namely, the second capacitor C2 is charged. The voltage across the second capacitor C2 is enhanced, and the voltage across the first capacitor C1 is maintained. The voltage difference between the second capacitor C2 and the first capacitor C1 is reduced.

In the time interval between t2 and t3, the first switch S1, the second switch S2, the third switch S3 and the fourth switch S4 are turned off. Regardless of whether a load current of the load is positive or negative, the voltage difference between the second capacitor C2 and the first capacitor C1 is maintained.

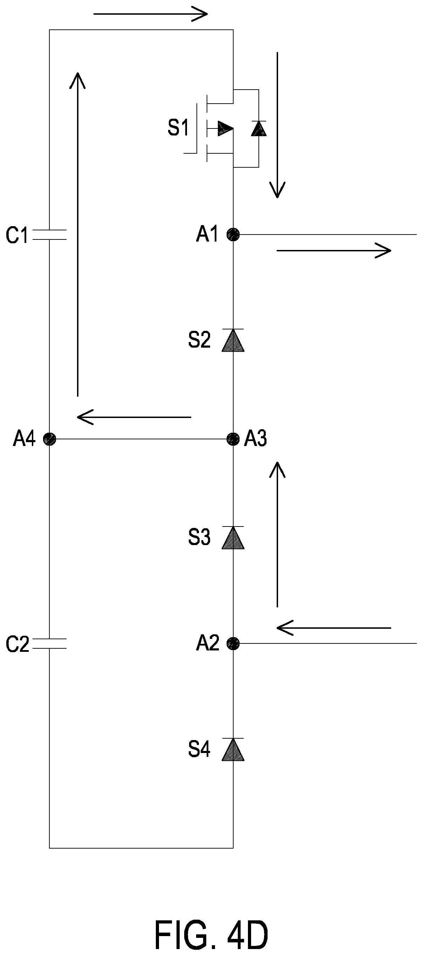

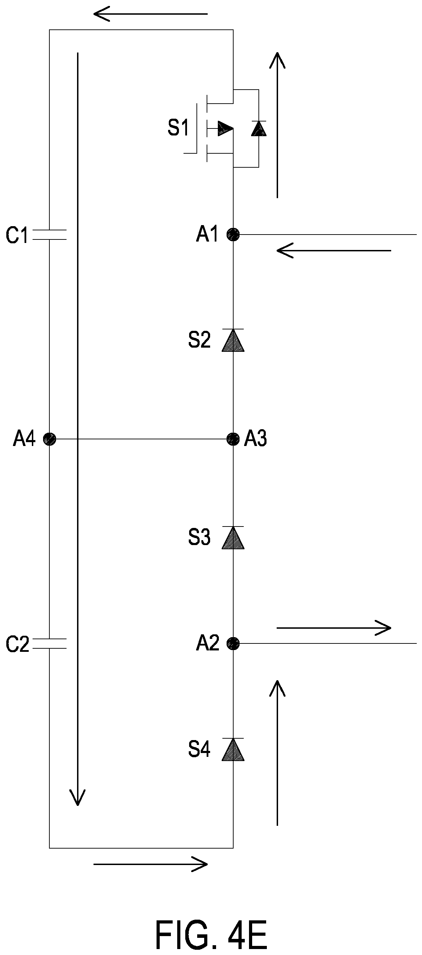

In the time interval between t3 and t4, the second switch S2, the third switch S3 and the fourth switch S4 are turned off, and the first switch S1 is turned on. When a load current of the load is positive, as shown in FIG. 4D, the load current is flowed through the second midpoint A2, the third switch S3, the first connection node A3, the second connection node A4, the first capacitor C1, the first switch S1 and the first midpoint A1 in sequence. Namely, the first capacitor C1 is discharged. The voltage across the first capacitor C1 is reduced, and the voltage across the second capacitor C2 is maintained. The voltage difference between the second capacitor C2 and the first capacitor C1 is reduced. When a load current of the load is negative, as shown in FIG. 4E, the load current is flowed through the first midpoint A1, the first switch S1, the first capacitor C1, the second capacitor C2, the fourth switch S4 and the second midpoint A2 in sequence. Namely, the voltage across the first capacitor C1 and the voltage across the second capacitor C2 are enhanced, respectively. The voltage difference between the second capacitor C2 and the first capacitor C1 is maintained.

Namely, in the time interval between t1 and t2, when the load current is negative, the second capacitor C2 is charged. In the time interval between t3 and t4, when the load current is positive, the first capacitor C1 is discharged. The voltage difference between the second capacitor C2 and the first capacitor C1 is reduced when the voltage across the first capacitor C1 is less than the voltage across the second capacitor C2. The voltage is balanced.

In this embodiment, the voltage balancing in each serial-half-bridge subcircuit 31, 32 and 33 are implemented under control of the controller 4, respectively. One of the four switches S1, S2, S3, S4 of each serial-half-bridge subcircuit 31, 32 and 33 is turned on within one time interval. However, the number of the time interval and the deadtime are not limited and can be varied according to practical requirements.

From above, the power switch system 1 includes a controller 4. The controller 4 is configured to adjust a first deadtime td1 between the first switch S1 and the second switch S2 and a second deadtime td2 between the third switch S3 and the fourth switch S4 according to the plurality of control signals. Consequently, when the voltage across the first capacitor C1 and the voltage across the second capacitor C2 are not balanced first, the voltage across the first capacitor C1 and the voltage across the second capacitor C2 are adjusted according to different situations. The voltage difference between the second capacitor C2 and the first capacitor C1 is reduced. Consequently, the rate of change of voltage with respect to time of the power switch system 1 during the operation is reduced. The efficiency of the power switch system 1 is enhanced. The EMI noise of the power switch system 1 is reduced.

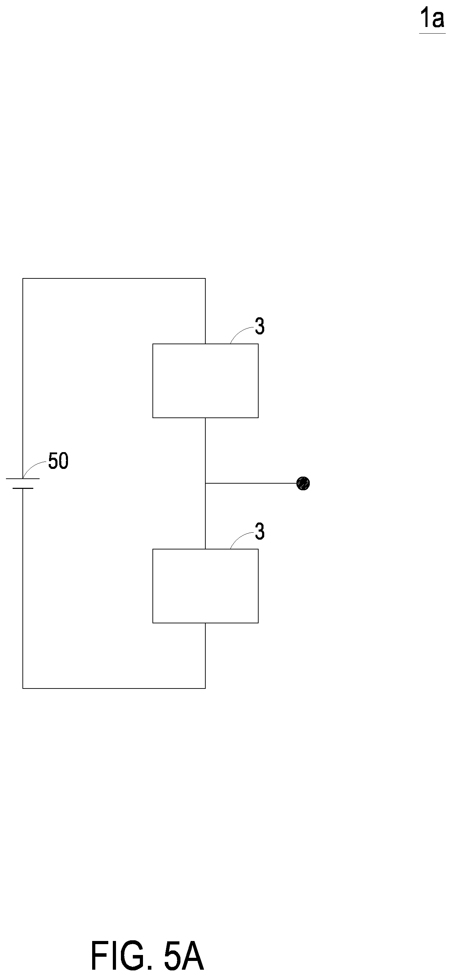

In some embodiments, the power switch system includes a plurality of subcircuit modules. FIG. 5A is a schematic circuit view illustrating a power switch system according to a second embodiment of the present disclosure. As shown in FIG. 5A, the power switch system 1a of this embodiment is connected to an input source 50 and includes two subcircuit modules 3. The two subcircuit modules 3 are connected to each other in series between two ends of the input source 50 to form a half bridge circuit. The midpoint between the two subcircuit modules 3 forms an output terminal.

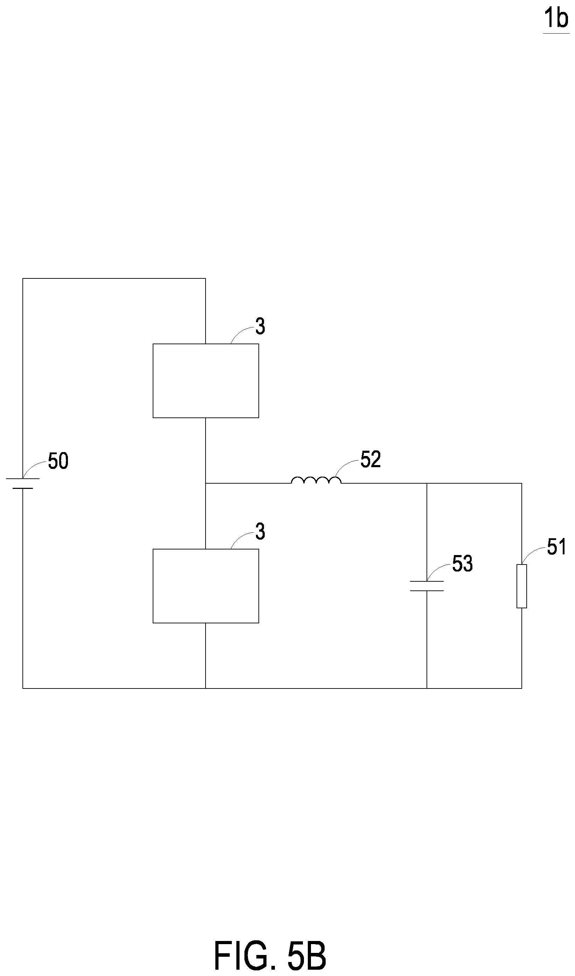

FIG. 5B is a schematic circuit view illustrating a power switch system according to a third embodiment of the present disclosure. As shown in FIG. 5B, the power switch system 1b of this embodiment is connected between an input source 50 and a load 51 and includes two subcircuit modules 3, an inductor 52 and a capacitor 53 to form a buck circuit. The two subcircuit modules 3 are connected to each other in series between two ends of the input source 50. The midpoint between the two subcircuit modules 3 is connected to a first end of the inductor 52. A second end of the inductor 52 is connected to a first end of the capacitor 53. A second end of the capacitor 53 is connected to the negative terminal of the input source 50.

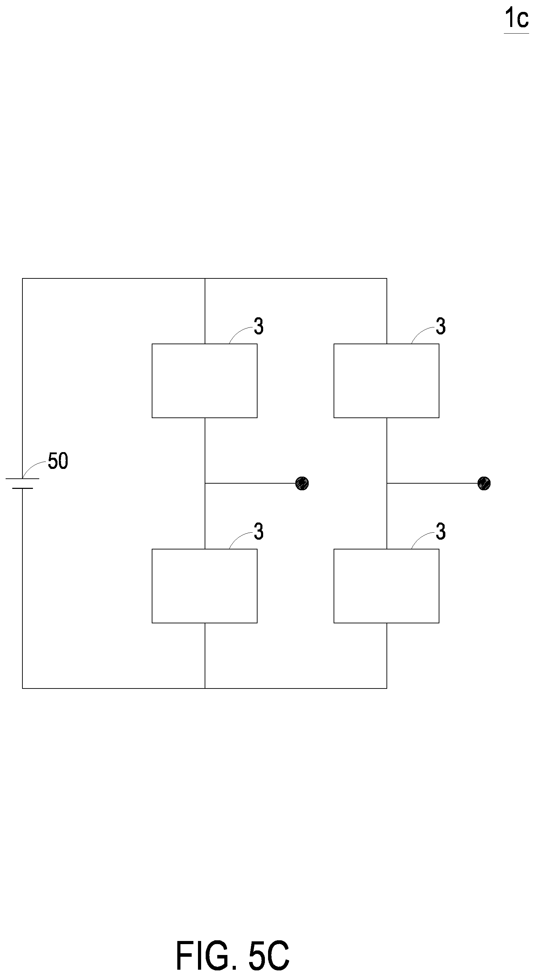

FIG. 5C is a schematic circuit view illustrating a power switch system according to a fourth embodiment of the present disclosure. As shown in FIG. 5C, the power switch system 1c of this embodiment is connected to an input source 50 and includes four subcircuit modules 3. Two of the four subcircuit modules 3 are connected to each other in series between two ends of the input source 50, and the other two of the four subcircuit modules 3 are connected to each other in series between two ends of the input source 50 to form a full bridge circuit. The midpoint between two of the four subcircuit modules 3 forms a first output terminal. The midpoint between the other two of the four subcircuit modules 3 forms a second output terminal.

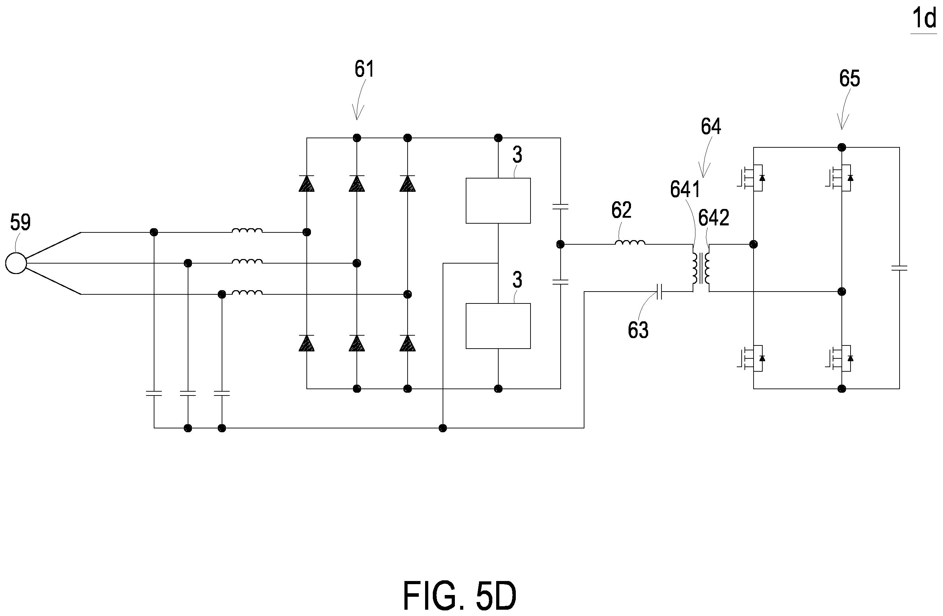

FIG. 5D is a schematic circuit view illustrating a power switch system according to a fifth embodiment of the present disclosure. As shown in FIG. 5D, the power switch system 1d of this embodiment is connected to a three-phase input source 59 and includes a primary circuit 61, two subcircuit modules 3, a resonant inductor 62, a resonant capacitor 63, a transformer 64 and a secondary circuit 65. The two subcircuit modules 3 are connected to each other in series and connected in parallel to the primary circuit 61. The transformer 64 includes a primary winding 641 and a secondary winding 642. The resonant inductor 62 is connected between a first end of the primary winding 641 and the primary circuit 61. The resonant capacitor 63 is connected between a second end of the primary winding 641 and the midpoint between the two subcircuit modules 3. The secondary circuit 65 is connected to the secondary winding 642.

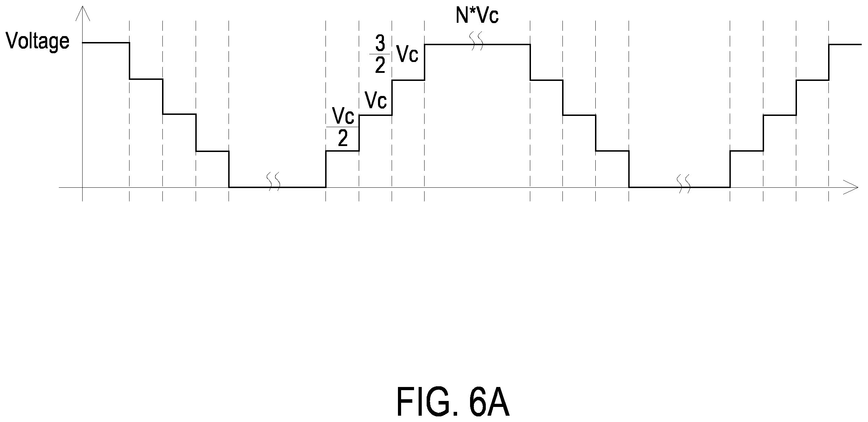

In an embodiment, each of the subcircuit modules 3 generates a multilevel voltage between the first terminal 21 and the second terminal 22. For example, each subcircuit module 3 includes N serial-half-bridge subcircuits. Each of the N serial-half-bridge subcircuits generates a corresponding three-level voltage. The output voltage of each subcircuit module 3 includes 2N discrete voltage levels. For example, as shown in FIG. 6A, the 2N discrete voltage levels consist of zero, half of the capacitor voltage (i.e., $\frac{Vc}{2}$), the capacitor voltage (i.e., Vc), one and a half times of the capacitor voltage (i.e., $\frac{3 Vc}{2}$), ... N times of the capacitor voltage (N*Vc) in sequence.

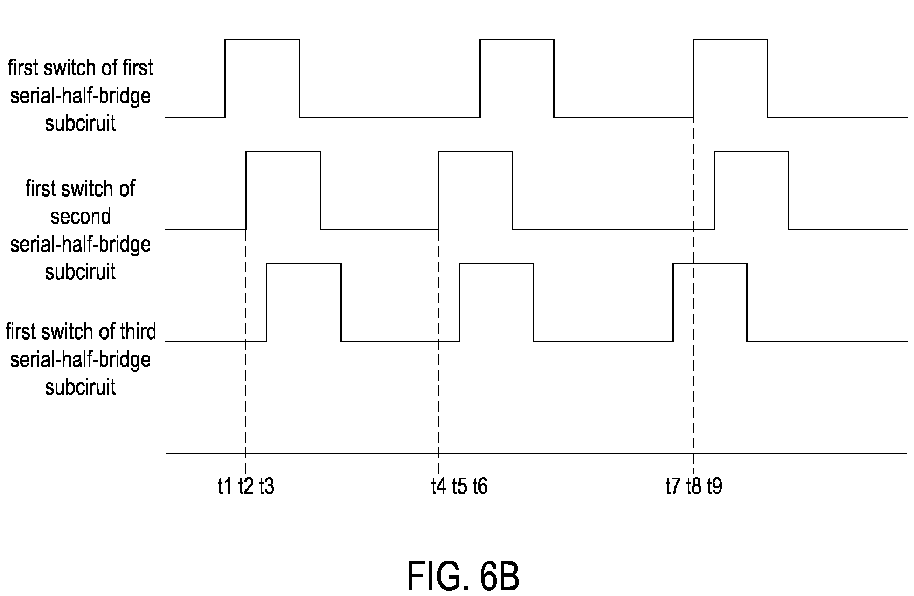

In some embodiments, the voltage between all serial-half-bridge subcircuits should be balanced. Namely, the voltages of the capacitors of each serial-half-bridge subcircuit have to be maintained at same level. FIG. 6B shows waveforms of operations of the first switches of the three serial-half-bridge subcircuits of the power switch system of FIG. 1. As shown in FIG. 1, the controller 4 is configured to generate a plurality of control signals to control the operation of the four switches of each of the three serial-half-bridge subcircuits 3. In this embodiment, the operations of the first switches of the three serial-half-bridge subcircuits 3 are shown in FIG. 6B as an example. As shown in FIG. 6B, in the first period, i.e., time interval between t1 and t4, the first switch S1 of the first serial-half-bridge subcircuit 31 is controlled to turn on first at time t1. Then, the first switch S1 of the second serial-half-bridge subcircuit 32 is controlled to turn on after a delay time (i.e., time interval between t1 and t2). Then, the first switch S1 of the third serial-half-bridge subcircuit 33 is controlled to turn on after the delay time (i.e., time interval between t2 and t3). Namely, in the first period, the first switch S1 of the first serial-half-bridge subcircuit 31, the first switch S1 of the second serial-half-bridge subcircuit 32 and the first switch S1 of the third serial-half-bridge subcircuit 33 are turned on in sequence.

In the second period, i.e., time interval between t4 and t7, the first switch S1 of the second serial-half-bridge subcircuit 32 is controlled to turn on first at time t4. Then, the first switch S1 of the third serial-half-bridge subcircuit 33 is controlled to turn on after a delay time (i.e., time interval between t4 and t5). Then, the first switch S1 of the first serial-half-bridge subcircuit 31 is controlled to turn on after the delay time (i.e., time interval between t5 and t6). Namely, in the second period, the first switch S1 of the second serial-half-bridge subcircuit 32, the first switch S1 of the third serial-half-bridge subcircuit 33 and the first switch S1 of the first serial-half-bridge subcircuit 31 are turned on in sequence.

In the third period, i.e., time interval after t7, the first switch S1 of the third serial-half-bridge subcircuit 33 is controlled to turn on first at time t7. Then, the first switch S1 of the first serial-half-bridge subcircuit 31 is controlled to turn on after a delay time (i.e., time interval between t7 and t8). Then, the first switch S1 of the second serial-half-bridge subcircuit 32 is controlled to turn on after the delay time (i.e., time interval between t8 and t9). Namely, in the third period, the first switch S1 of the third serial-half-bridge subcircuit 33, the first switch S1 of the first serial-half-bridge subcircuit 31 and the first switch S1 of the second serial-half-bridge subcircuit 32 are turned on in sequence. Namely, in this embodiment, the first switches of the three serial-half-bridge subcircuits 31, 32, 33 are controlled according to a plurality of control sequences that are cyclically arranged.

In this embodiment, the number of the period is equal to the number of the serial-half-bridge subcircuits. In this embodiment, the delay time is less than the first period, the second period and the third period.

In some embodiments, the time of the switches of the serial-half-bridge subcircuit controlled to turn on has (or has not) delay time, and/ or the time of the switches of the serial-half-bridge subcircuit controlled to turn off has (or has not) delay time.

Certainly, the second switches S2, the third switches S3 and the fourth switches S4 of each of the serial-half-bridge subcircuits are controlled with the same method, and is not redundantly described hereinafter. Certainly, the control method of FIGS. 3A or 4A can be utilized and executed by the controller 4 at the same time. Namely, the control method of FIGS. 3A or 4A of the second switches S2, the third switches S3 and the fourth switches S4 of each of the serial-half-bridge subcircuits is utilized and executed by the controller 4 at the same period.

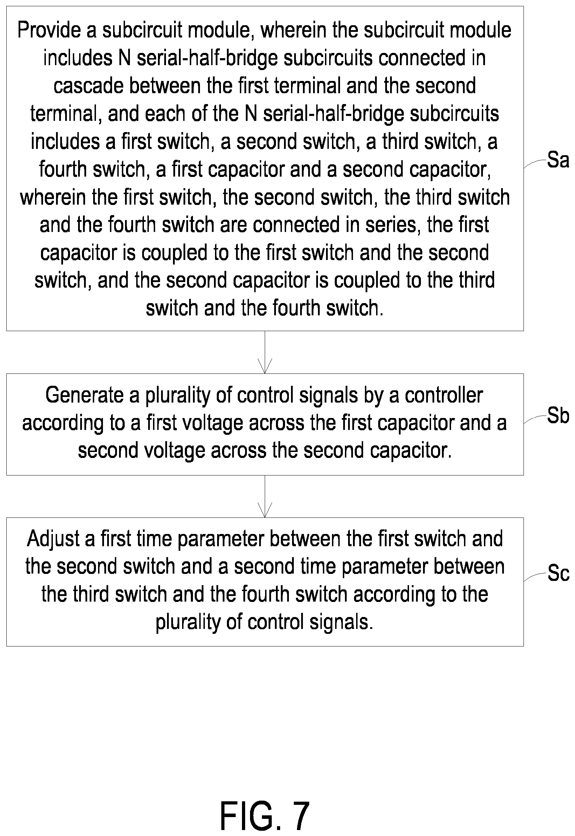

In accordance with the technical features of the present disclosure, a control method for the power switch system 1 is provided. FIG. 7 is a flow chart illustrating the control method for the power switch system of FIG. 1 according to a first embodiment of the present disclosure. In an embodiment, the control method for the power switch system 1 includes the following steps. Firstly, step (Sa) is performed to provide a subcircuit module 3. The subcircuit module 3 includes N serial-half-bridge subcircuits 31, 32, 33 connected in cascade between the first terminal 21 and the second terminal 22. Each of the N serial-half-bridge subcircuits 31, 32, 33 includes a first switch S1, a second switch S2, a third switch S3, a fourth switch S4, a first capacitor C1 and a second capacitor C2. The first switch S1, the second switch S2, the third switch S3 and the fourth switch S4 are connected in series, the first capacitor C1 is coupled to the first switch S1 and the second switch S2, and the second capacitor C2 is coupled to the third switch S3 and the fourth switch S4. Then, step (Sb) is performed by a controller 4 to generate a plurality of control signals according to a first voltage across the first capacitor C1 and a second voltage across the second capacitor C2. Then, step (Sc) is performed to adjust a first timing parameter between the first switch S1 and the second switch S2 and a second timing parameter between the third switch S3 and the fourth switch S4 according to the plurality of control signals. In some embodiments, in the step (Sc), the control method further includes step of adjusting the first timing parameter to be greater than the second timing parameter by the controller 4 when the second voltage across the second capacitor C2 is greater than the first voltage across the first capacitor C1, and adjusting the first timing parameter to be less than the second timing parameter by the controller 4 when the second voltage across the second capacitor C2 is less than the first voltage across the first capacitor C1. Preferably but not exclusively, the first timing parameter is the first deadtime td1, and the second time parameter is the second deadtime td2. The control method executed by the controller 4 has been described in detail as the above embodiments and are not redundantly described hereinafter.

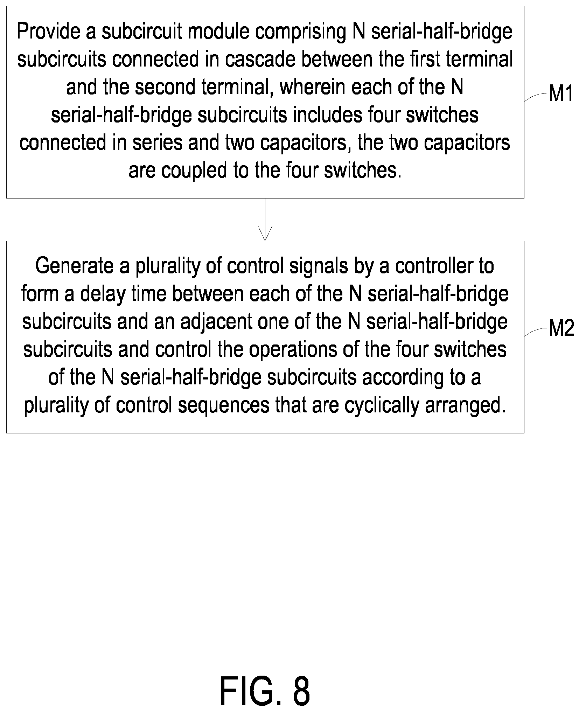

FIG. 8 is a flow chart illustrating the control method for the power switch system of FIG. 1 according to a second embodiment of the present disclosure. In an embodiment, the control method for the power switch system 1 includes the following steps. Firstly, step (M1) is performed to provide a subcircuit module 3. The subcircuit module 3 includes N serial-half-bridge subcircuits 31, 32, 33 connected in cascade between the first terminal 21 and the second terminal 22. Each of the N serial-half-bridge subcircuits 31, 32, 33 includes four switches S1, S2, S3, S4 connected in series and two capacitors C1, C2, and the two capacitors C1, C2 are coupled to the four switches S1, S2, S3, S4. Then, step (M2) is executed by a controller 4 to generate a plurality of control signals to form a delay time between each of the N serial-half-bridge subcircuits 31, 32, 33 and an adjacent one of the N serial-half-bridge subcircuits 31, 32, 33 and control the operations of the four switches S1, S2, S3, S4 of the N serial-half-bridge subcircuits 31, 32, 33 according to a plurality of control sequences that are cyclically arranged. In an embodiment, the N serial-half-bridge subcircuits 31, 32, 33 includes a first serial-half-bridge subcircuit 31, a second serial-half-bridge subcircuit 32 and a third serial-half-bridge subcircuit 33. In a first period, the controller 4 controls one of the four switches S1, S2, S3, S4 of the first serial-half-bridge subcircuit 31 to be turned on, then controls one of the four switches S1, S2, S3, S4 of the second serial-half-bridge subcircuit 32 to be turned on after the delay time, and then controls one of the four switches S1, S2, S3, S4 of the third serial-half-bridge subcircuit 33 to be turned on after the delay time. In a second period, the controller 4 controls one of the four switches S1, S2, S3, S4 of the second serial-half-bridge subcircuit 32 to be turned on, then controls one of the four switches S1, S2, S3, S4 of the third serial-half-bridge subcircuit 33 to be turned on after the delay time, and then controls one of the four switches S1, S2, S3, S4 of the first serial-half-bridge subcircuit 31 to be turned on after the delay time. In a third period, the controller 4 controls one of the four switches S1, S2, S3, S4 of the third serial-half-bridge subcircuit 33 to be turned on, then controls one of the four switches S1, S2, S3, S4 of the first serial-half-bridge subcircuit 31 to be turned on after the delay time, and then controls one of the four switches S1, S2, S3, S4 of the second serial-half-bridge subcircuit 32 to be turned on after the delay time. Preferably, the delay time is less than the first period, the second period and the third period.

With the above controlling methods, the voltage of each of the serial-half-bridge subcircuits is actively controlled to remain equal to that of the others. Instead of using a fixed predefined delay, the delay time is slightly modified based on the measured deviation from the desired voltage. Consequently, the voltage imbalance including but not limited to component parameter tolerances, propagation delays in control signals, and other system variations is solved. The net charge transfer over the periods will be slightly positive when the input source is low and slightly negative when the input source is high. Consequently, voltage balance across all of the serial-half-bridge subcircuits is maintained.

From the above description, the power switch system includes a controller. The controller is configured to adjust a first timing parameter between the first switch and the second switch and a second timing parameter between the third switch and the fourth switch according to the plurality of control signals. Consequently, when the voltage across the first capacitor and the voltage across the second capacitor are not balanced first, the voltage across the first capacitor and the voltage across the second capacitor are adjusted according to different situations. The voltage difference between the second capacitor and the first capacitor is reduced. Consequently, the rate of change of voltage with respect to time of the power switch system during the operation is reduced. The efficiency of the power switch system is enhanced. The EMI noise of the power switch system is reduced.

## Claims

1. A control method for a power switch system (1, 1a, 1b, 1c, 1d) having a first terminal (21) and a second terminal (22), **characterized in that** the control method comprises:
(Sa) providing a subcircuit module (3) comprising N serial-half-bridge subcircuits (31, 32, 33) connected in cascade between the first terminal (21) and the second terminal (22), wherein each of the N serial-half-bridge subcircuits (31, 32, 33) comprises a first switch (S1), a second switch (S2), a third switch (S3), a fourth switch (S4), a first capacitor (C1) and a second capacitor (C2), wherein the first switch (S1), the second switch (S2), the third switch (S3) and the fourth switch (S4) are connected in series, the first capacitor (C1) is coupled to the first switch (S1) and the second switch (S2), and the second capacitor (C2) is coupled to the third switch (S3) and the fourth switch (S4);
(Sb) generating a plurality of control signals by a controller (4) according to a first voltage across the first capacitor (C1) and a second voltage across the second capacitor (C2); and
(Sc) adjusting a first timing parameter between the first switch (S1) and the second switch (S2), and a second timing parameter between the third switch (S3) and the fourth switch (S4) according to the plurality of control signals.

2. The control method according to claim 1, wherein in the step (Sc), the control method further comprises a step of adjusting the first timing parameter to be greater than the second timing parameter by the controller (4) when the second voltage across the second capacitor (C2) is greater than the first voltage across the first capacitor (C1), the control method further comprises a step of adjusting the first timing parameter to be less than the second timing parameter by the controller (4) when the second voltage across the second capacitor (C2) is less than the first voltage across the first capacitor (C1).

3. The control method according to claim 1, wherein in the step (Sb), the plurality of control signals comprises a first control signal, a second control signal, a third control signal and a fourth control signal, wherein the first switch (S1), the second switch (S2), the third switch (S3) and the fourth switch (S4) are controlled to be turned on or turned off by the first control signal, the second control signal, the third control signal and the fourth control signal, respectively, wherein the first control signal and the second control signal are complementary, and the third control signal and the fourth control signal are complementary.

4. The control method according to claim 1, wherein one of the first switch (S1), the second switch (S2), the third switch (S3) and the fourth switch (S4) of each of the N serial-half-bridge subcircuits (31, 32, 33) is turned on within one time interval.

5. A control method of a power switch system (1, 1a, 1b, 1c, 1d), the power switch system (1, 1a, 1b, 1c, 1d) comprising a first terminal (21) and a second terminal (22), and **characterized in that** the control method comprises:
providing a subcircuit module (3) comprising N serial-half-bridge subcircuits (31, 32, 33) connected in cascade between the first terminal (21) and the second terminal (22), wherein each of the N serial-half-bridge subcircuits (31, 32, 33) comprises four switches connected in series and two capacitors, the two capacitors are coupled to the four switches; and
generating a plurality of control signals by a controller (4) to form a delay time between each of the N serial-half-bridge subcircuits (31, 32, 33) and an adjacent one of the N serial-half-bridge subcircuits (31, 32, 33) and controlling the operations of the four switches of the N serial-half-bridge subcircuits (31, 32, 33) according to a plurality of control sequences that are cyclically arranged.

6. The control method according to claim 5, wherein the N serial-half-bridge subcircuits (31, 32, 33) comprise a first serial-half-bridge subcircuit (31), a second serial-half-bridge subcircuit (32) and a third serial-half-bridge subcircuit (33), wherein the control method further comprises steps of: in a first period, controlling one of the four switches of the first serial-half-bridge subcircuit (31) to turn on, then controlling one of the four switches of the second serial-half-bridge subcircuit (32) to turn on after the delay time, and then controlling one of the four switches of the third serial-half-bridge subcircuit (33) to turn on after the delay time; in a second period, controlling one of the four switches of the second serial-half-bridge subcircuit (32) to turn on, then controlling one of the four switches of the third serial-half-bridge subcircuit (33) to turn on after the delay time, and then controlling one of the four switches of the first serial-half-bridge subcircuit (31) to turn on after the delay time; in a third period, controlling one of the four switches of the third serial-half-bridge subcircuit (33) to turn on, then controlling one of the four switches of the first serial-half-bridge subcircuit (31) to turn on after the delay time, and then controlling one of the four switches of the second serial-half-bridge subcircuit (32) to turn on after the delay time, wherein the delay time is less than the first period, the second period and the third period.

7. A power switch system (1, 1a, 1b, 1c, 1d), **characterized by** comprising:
a first terminal (21) and a second terminal (22);
a subcircuit module (3) comprising N serial-half-bridge subcircuits (31, 32, 33) connected in cascade between the first terminal (21) and the second terminal (22), wherein each of the N serial-half-bridge subcircuits (31, 32, 33) comprises:
a first switch (S1), a second switch (S2), a third switch (S3) and a fourth switch (S4) connected in series; and
a first capacitor (C1) and a second capacitor (C2), wherein the first capacitor (C1) is coupled to the first switch (S1) and the second switch (S2), and the second capacitor (C2) is coupled to the third switch (S3) and the fourth switch (S4); and
a controller (4) configured to generate a plurality of control signals according to a first voltage across the first capacitor (C1) and a second voltage across the second capacitor (C2), wherein a first timing parameter between the first switch (S1) and the second switch (S2), and a second timing parameter between the third switch (S3) and the fourth switch (S4) are adjusted according to the plurality of control signals.

8. The power switch system (1, 1a, 1b, 1c, 1d) according to claim 7, wherein the first timing parameter is adjusted to be greater than the second timing parameter by the controller (4) when the second voltage across the second capacitor (C2) is greater than the first voltage across the first capacitor (C1), wherein the first timing parameter is adjusted to be less than the second timing parameter by the controller (4) when the second voltage across the second capacitor (C2) is less than the first voltage across the first capacitor (C1).

9. The power switch system (1, 1a, 1b, 1c, 1d) according to claim 7, wherein the plurality of control signals comprises a first control signal, a second control signal, a third control signal and a fourth control signal, wherein the first switch (S1), the second switch (S2), the third switch (S3) and the fourth switch (S4) are controlled to be turned on or turned off by the first control signal, the second control signal, the third control signal and the fourth control signal, respectively, wherein the first control signal and the second control signal are complementary, and the third control signal and the fourth control signal are complementary.

10. The power switch system (1, 1a, 1b, 1c, 1d) according to claim 7, wherein one of the first switch (S1), the second switch (S2), the third switch (S3) and the fourth switch (S4) of each of the N serial-half-bridge subcircuits (31, 32, 33) is turned on within one time interval.

11. The power switch system (1, 1a, 1b, 1c, 1d) according to claim 7, wherein a first midpoint (A1) is formed between the first switch (S1) and the second switch (S2) of each of the N serial-half-bridge subcircuits (31, 32, 33), a second midpoint (A2) is formed between the third switch (S3) and the fourth switch (S4) of each of the N serial-half-bridge subcircuits (31, 32, 33), the first midpoint (A1) of a first serial-half-bridge subcircuit of the N serial-half-bridge subcircuits (31, 32, 33) is connected to the first terminal (21), the first midpoint (A1) of an n-th serial-half-bridge subcircuit of the N serial-half-bridge subcircuits (31, 32, 33) is connected to the second midpoint (A2) of a (n-1)-th serial-half-bridge subcircuit of the N serial-half-bridge subcircuits (31, 32, 33), the second midpoint (A2) of a last serial-half-bridge subcircuit of the N serial-half-bridge subcircuits (31, 32, 33) is connected to the second terminal (22), wherein N≥n≥2.

12. The power switch system (1, 1a, 1b, 1c, 1d) according to claim 7, wherein the power switch system (1, 1a, 1b, 1c, 1d) comprises a plurality of subcircuit modules (3), wherein the plurality of subcircuit modules (3) are connected to each other to form a half bridge circuit, a buck circuit, or a full bridge circuit.

13. The power switch system (1d) according to claim 7, wherein the power switch system (1d) comprises a primary circuit (61), a resonant inductor (62), a resonant capacitor (63), a transformer (64) and a secondary circuit (65), wherein the subcircuit module (3) is electrically connected to the primary circuit (61) in parallel, the transformer (64) comprises a primary winding and a secondary winding, the resonant inductor (62) is connected between a first end of the primary winding and the primary circuit (61), the resonant capacitor (63) is connected between a second end of the primary winding and the subcircuit module (3), and the secondary circuit (65) is connected to the secondary winding.

14. The power switch system (1, 1a, 1b, 1c, 1d) according to claim 7, wherein the controller (4) is configured to form a delay time between each of the N serial-half-bridge subcircuits (31, 32, 33) and an adjacent one of the N serial-half-bridge subcircuits (31, 32, 33), wherein the controller (4) is configured to control the four switches of the N serial-half-bridge subcircuits (31, 32, 33) according to a plurality of control sequences that are cyclically arranged.

15. The power switch system (1, 1a, 1b, 1c, 1d) according to claim 14, wherein the N serial-half-bridge subcircuits (31, 32, 33) comprise a first serial-half-bridge subcircuit (31), a second serial-half-bridge subcircuit (32) and a third serial-half-bridge subcircuit (33), wherein in a first period, the controller (4) turns on one of the four switches of the first serial-half-bridge subcircuit (31),, then turns on one of the four switches of the second serial-half-bridge subcircuit (32) after the delay time, and then turns on one of the four switches of the third serial-half-bridge subcircuit (33) after the delay time; in a second period, the controller (4) turns on one of the four switches of the second serial-half-bridge subcircuit (32), then turns on one of the four switches of the third serial-half-bridge subcircuit (33) after the delay time, and then turns on one of the four switches of the first serial-half-bridge subcircuit (31), after the delay time; in a third period, the controller (4) turns on one of the four switches of the third serial-half-bridge subcircuit (33), then turns on one of the four switches of the first serial-half-bridge subcircuit (31), after the delay time, and then turns on one of the four switches of the second serial-half-bridge subcircuit (32) after the delay time, wherein the delay time is less than the first period, the second period and the third period.
